(19) Europäisches Patentamt
European Patent Office
Office européen des brevets

(11) **EP 3 534 125 B1**

(12) **EUROPEAN PATENT SPECIFICATION**

(45) Date of publication and mention
of the grant of the patent:
**14.10.2020 Bulletin 2020/42**

(51) Int Cl.:
***G01K 7/02*** *(2006.01)*

(21) Application number: **19156754.4**

(22) Date of filing: **12.02.2019**

(54) **ELECTRIC DEVICE COMPRISING A PRINTED CIRCUIT BOARD AND METHOD FOR DETERMINING LOCAL TEMPERATURES AT DIFFERENT MEASUREMENT POINTS OF THE PRINTED CIRCUIT BOARD**

ELEKTRISCHE VORRICHTUNG MIT EINER LEITERPLATTE UND VERFAHREN ZUR BESTIMMUNG VON LOKALEN TEMPERATUREN AN VERSCHIEDENEN MESSPUNKTEN EINER LEITERPLATTE

DISPOSITIF ÉLECTRIQUE COMPRENANT UNE CARTE DE CIRCUIT IMPRIMÉ ET PROCÉDÉ PERMETTANT DE DÉTERMINER DES TEMPÉRATURES LOCALES À DIFFÉRENTS POINTS DE MESURE DE LA CARTE DE CIRCUIT IMPRIMÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.02.2018 GB 201803220**

(43) Date of publication of application:
**04.09.2019 Bulletin 2019/36**

(73) Proprietor: **Vitesco Technologies GmbH**
**30165 Hannover (DE)**

(72) Inventors:
• **Gajdarus, Tomá**
**CZ 70200 Ostrava (CZ)**

• **Filipec, Ales**
**74213 Studénka (CZ)**

(74) Representative: **Waldmann, Georg Alexander**
**Continental Automotive GmbH**
**Patente und Lizenzen**
**Postfach 22 16 39**
**80506 München (DE)**

(56) References cited:
**WO-A1-2011/094658     WO-A1-2011/152776**
**US-A1- 2005 259 719**

**Description**

The invention is concerned with an electric device comprising a printed circuit board, PCB, or another circuitry and comprising a control unit. The control unit may determine a respective temperature at several measurement points on the circuitry. The invention also comprises a method for determining the local temperatures at the different measurement points of the circuitry.

One possible application where the temperature of a specific measurement point of a PCB must be known is an electric device where a thermocouple temperature sensor is connected to the PCB of the electric device. A thermocouple temperature sensor comprises a pair of thermocouple wires that are electrically connected together at the so-called hot junction (at a distance from the PCB) and that are connected to the PCB at the so-called cold end of the thermocouple. By measuring a voltage generated by the thermocouple at the cold end the relative temperature difference between the cold end and the hot junction can be determined.

In order to determine an absolute temperature value at the hot junction (and not only the relative temperature with respect to the cold end), the absolute temperature value of the cold end must also be determined. As the cold end is connected to the PCB, a temperature sensor for measuring an absolute temperature value may be arranged on the PCB in the region of the cold end of the thermocouple wires. US 9279731 A discloses such an arrangement. One problem with this solution is that for the case that several thermocouple temperature sensors are to be connected to the PCB, a respective temperature sensor for measuring the absolute temperature value of the respective cold end is needed for each connected pair of thermocouple wires. This makes the electric device expensive regarding production costs.

US 6472612 A discloses an electric device with a control unit that measures a temperature at a specific measurement point of a printed circuit board by means of a pair of thermocouple wires. For the measurement of the temperature, two electric contacts are directly connected to the control unit, i.e. a microcontroller. This requires a control unit with two electric contact pads or measurement pads per measurement point. For N measurement points, this results in 2*N pads.

US 5180440 A discloses a printed circuit board with a thermocouple arrangement for measuring the temperature inside a drilling hole or VIA (vertical interconnect access) of the printed circuit board. The arrangement of the thermocouple materials allows for measuring a respective temperature in several different layers of a multilayer printed circuit board. The measurement at several different measurement points within the same layer, e.g. several measurement points on the surface, is not described.

US 7603205 A discloses the measurement of a temperature gradient on the surface of a printed circuit board. For determining the temperature gradient, several independent temperature sensors are needed each of which may be based on a thermocouple matrix. Each temperature sensor needs an individual electric connection to an evaluating control unit.

US 9285278 A discloses determining the temperature gradient of a printed circuit board by means of two temperature sensors and a digital model for calculating gradient values. The temperature readings of the temperature sensors form an input for the digital model. The more input is wanted for a more precise prediction of the temperature gradient, the more temperature sensors and the more wiring is needed.

Document US 2005/259719 A1 discloses a multi-element thermocouple circuit with a tree-like structure for providing several measurement points at which the temperature may be measured. The tree-like structure may be based on wires made of a noble material and the material may be obtained as an off-the-shelf thermocouple probe. In one embodiment, the material for forming thermocouple elements may be deposited on a thermally conductive and electrically non-conductive substrate.

Document WO 2011/094658 A1 discloses a thin-film thermocouple that may be placed on a metal blade of a turbine. The materials for providing a thermocouple elements are placed on the same surface where they are electrically connected.

Document WO2011/152776 A1 discloses a circuitry for measuring the voltage that is generated by thermocouple elements that are connected to that circuitry as separate temperature sensors. For providing a measurement of a reference temperature, the circuitry may comprise an additional temperature sensor.

It is an object of the invention to provide a respective temperature measurement at several different measurement points of a circuitry, like, e.g., a printed circuit board.

The object is accomplished by the subject matter of the independent claims. Advantageous further embodiments of the invention are specified in the following description, the dependent claims and the figures.

The invention provides an electric device comprising a circuitry and a control unit. The control unit is designed to determine local temperature values at N different measurement points of the circuitry, wherein N is equal to or greater than 2 or 3 or 4 or 5 and wherein the control unit is electrically connected to the measurement points by electric conductor elements.

According to the invention the conductor elements form a tree structure that connects all measurement points to the control unit, wherein starting from at least one measurement point forming a respective root of the tree structure a respective pair of conductor elements begins at each measurement point, the pair forming a thermocouple at the respective measurement point and each conductor element of the pair leading to either a measurement point of a lower level of the tree structure or to the control unit, wherein at the control unit only N+1 conductor elements of the tree structure are electrically connected to measurement pads of the control unit and wherein the control unit is designed to determine the respective temperature value of each measurement point as a function of a respective voltage that is produced between the measurement pads by the thermocouples. The tree structure may have one root or more than one root.

In other words, the tree structure is built from conductor elements and at each measurement point one or at least one conductor element is forked. Such an electric conductor element can be, e.g., a wire or a track of a layer of the circuitry, e.g. a track of a PCB. Each fork of the tree structure is made of a pair of conductor elements that form a thermocouple for measuring the respective relative temperature at the respective measurement point. For providing a respective thermocouple arrangement (or in short a thermocouple), one conductor element of the pair on one side and the other conductor element of the pair on the other side may at least partially comprise different materials. The respective materials can be a metal or an alloy. For example, one material can be constantan, whereas the other material can be copper. Another example is the combination of the two materials Nicrosil (NiCrSi) and Nisil (NiSi). Combinations for forming a thermocouple arrangement are readily known in the prior art. The control unit is designed to determine the respective temperature of each measurement point as a function of a respective voltage that is produced between the respective conductor elements of the pairs at the measurement points. These voltages can be directly or indirectly determined by measuring the voltages at the N+1 pads. The pad can be the input of an analog-to-digital converter.

In other words, the control unit measures relative temperatures by using a respective thermocouple arrangement for each measurement point. Each measurement point is the hot junction of the respective thermocouple. Note that the respective conductor elements of each pair may end at the control unit, i.e. they may lead to the control unit, or they may lead to another measurement point.

The invention provides the advantage that only N+1 measurement pads are needed at the control unit for measuring the local temperature values at N measurement points.

The circuitry is based on a printed circuit board or a foil with integrated electrically conductive tracks. The control unit may be based on, e.g., a microcontroller. The circuitry may extend parallel to a plane or has a length and the width in the plane and a thickness measured perpendicular to the plane. The thickness is the direction of the smallest extension of the circuitry. The circuitry may also have a bent shape, like a bent foil. The circuitry may comprise one or more layers each comprising electrically conductive tracks, e.g. copper tracks. Electronic elements (e.g. connectors and/or integrated circuits) may be arranged on the circuitry. Each layer of the circuitry may extend parallel to the surface of the PCB or the foil.

The control unit is designed to determine local temperatures at N different measurement points of the circuitry, especially in one layer, like, e.g., at the surface of the circuitry or in another layer of the circuitry. For example, two or three or four or five or more than five measurement points can be provided. These measurement points are arranged at a distance to the control unit. They are also distant from each other. For example, the distance between the measurement points and the control unit may be greater than 5 millimeters, particularly greater than 10 millimeters. The distance between the measurement points can be greater than 5 millimeters, particularly greater than 10 millimeters.

According to the invention, the materials for forming the respective thermocouple are provided by different layers of the circuitry. For example, in the case that the circuitry is a multilayer printed circuit board, one conductor element of a pair forming the thermocouple can be provided by one layer and the other conductor element of that pair can be provided by another layer of the circuitry. The layers can be electrically connected at each measurement point by means of VIAs. This connection also forms the hot junction of the thermocouple.

The invention also comprises embodiments which afford additional technical advantages.

Each conductor element may be provided as one respective homogeneous wire or track made of one material. The conductor elements or at least one of them may however comprise at least two different homogeneous segments, i.e. two or more segments, each of a different material. Accordingly, in one embodiment at least one conductor element is constructed of several segments of different material. A change of material within the respective conductor element occurs at a respective point of known temperature, though. This provides the advantage that the path of the respective conductor element may be routed through two or more different layers of the circuitry, e.g. two or more different layers of PCB. This provides a greater flexibility in the circuit design.

For providing a point of known temperature, at the respective point of known temperature a temperature sensor may be positioned or the point of known temperature may be within a pre-defined range of one of the measurement points. The range can be less than 1 cm, preferably less than 5 mm. In other word, the change of material within a respective conductor element may occur at a temperature sensor (e.g. a PTC sensor, PTC - positive temperature coefficient) or with said range of a measurement point.

In one embodiment the function that is used for calculating the temperature in dependence on the measured voltage is based on the thermoelectric effect and describes a relative temperature difference between the control unit and the respective measurement point. Such a function can be taken from the prior art. The embodiment provides the advantage that the relative temperature difference between the control unit on one side and the respective measurement point on the other side is known or determined by the control unit.

In one embodiment a temperature sensor for sensing an absolute temperature value is positioned at the control unit and the control unit is designed to determine a respective absolute temperature value for one or several or all of the measurement points on the basis of the measured absolute temperature value and the respective temperature value of the measurement point. In other words, the absolute temperature value at the control unit is measured. As the control unit can form the cold end for each thermocouple constituted by the pairs of conductor elements at the measurement points. Thus, only one single temperature sensor is sufficient for determining the absolute temperature of each cold end. This embodiment provides the advantage that the absolute temperature value is known for at least one of the measurement points without placing a temperature sensor (for measuring the absolute temperature value) at this measurement point. Particularly, one single temperature sensor (for measuring the absolute temperature value) is sufficient for determining absolute temperature values at several different measurement points.

In one embodiment the circuitry comprises several connection units for connecting a respective pair of thermocouple wires of a respective external temperature sensor. This arrangement is already described in the introduction of this specification. The control unit is designed to determine a respective absolute temperature at each of the connection units as a function of the respective temperature value of each of the measurement points and as a function of the measured absolute temperature value measured by said temperature sensor arranged at the control unit. In other words, only one temperature sensor for measuring an absolute temperature value is needed for running several external temperature sensors that are based on thermocouple wires. This provides the advantage that the electric device can run several external temperature sensors with only one temperature sensor on the circuitry for measuring an absolute temperature value. The temperature sensor can be, e.g., an NTC resistor (NTC - negative temperature coefficient).

In one embodiment a heat distribution element is arranged in a connection area where the measurement pads of the control unit and the temperature sensor are arranged. The heat distribution element can be, e.g., a piece or a foil made of, e.g., metal or an alloy. In other words, by the heat distribution element heat energy is distributed evenly in the connection area. This provides the advantage that the temperature sensor on one side and each cold end of the thermocouple pairs (measurement pads) have the same temperature. The measurement of the absolute temperature values of each measurement point is therefore precise. The heat distribution element preferably covers the whole connection area.

In one embodiment an additional temperature sensor for measuring an additional absolute temperature value is arranged on the circuitry. Preferably the distance between the two temperature sensors is greater than 10 millimeters especially greater than 20 millimeters. The control unit is designed to determine a temperature difference value between the absolute temperature values of the temperature sensors and to generate an error signal, if the temperature difference value is greater than a predefined value. In other words the error signal is generated, if a temperature gradient between the two temperature sensors is greater than a predefined maximum gradient defined by the predefined value. This provides for a plausibility check on the basis of the measurement of two absolute temperature values.

Additionally or alternatively, signals from two absolute sensors are compared to each other and to the temperature values obtained from the measurement points (of the thermocouple network) . If any of these comparisons differs more than a predefined value, an error signal is generated.

In one embodiment the control unit is designed to calculate interpolated temperature values between the measurement points on the basis of the respective temperature value of each measurement point and on the basis of a predefined interpolation function. In other words, temperature values for additional, virtual measurement points between the actual, real measurement points are provided by interpolating the temperature values on the basis of the interpolation function. The interpolation function can be, e.g., a linear function. This provides the advantage that a temperature value can also be provided for a position or point of the circuitry where there is no real measurement point.

In one embodiment the control unit is designed to calculate a temperature gradient field along the circuitry on the basis of the respective temperature value of each measurement point and on the basis of a predefined heat dissipation model. This provides the advantage that data describing the flow of heat energy across the circuitry is provided. The heat dissipation model can be based on a differential equation and/or a finite elements model (FEM).

The circuitry is a printed circuit board or a foil with integrated electronically conductive tracks. The electronic circuit is designed to receive a supply voltage over to supply electrodes. The supply voltage is the voltage needed for running or driving or activating the circuit. One supply electrode is connected to one of the conductor elements of the tree structure and the other supply electrode is connected to another conductor element of the tree structure. In other words, the circuit receives the voltage generated by the thermocouple effect as a supply voltage. The electronic circuit can therefore run on the basis of a temperature difference between a measurement point and the position of the electronic circuit. No external power supply is needed.

By running the inventive electric device, a method is performed that is also part of the invention. The inventive method is for determining local temperatures at different measurement points of a circuitry of an electric device. The circuitry may extend in one plane (i.e. it has a length and a width in the plane) or it may comprise a bent shape. The described control unit determines local temperature values at N different measurement points of the circuitry, wherein N is equal to or greater than 2 or 3 or 4 or 5 and wherein the control unit is electrically connected to the measurement points by electric conductor elements. The conductor elements form a tree structure that connects all measurement points to the control unit, wherein starting from at least one measurement point forming a respective root of the tree structure a respective pair of conductor elements begins at each measurement point, the pair forming a thermocouple at the respective measurement point and each conductor element of the pair leading to either a measurement point of a lower level of the tree structure or to the control unit, wherein at the control unit N+1 conductor elements of the tree structure are electrically connected to measurement pads of the control unit and wherein the control unit determines the respective temperature value of each measurement point as a function of a respective voltage that is produced between the measurement pads by the thermocouples.

The invention also comprises embodiments of the inventive method that comprise features that have already been described in connection with the embodiments of the inventive electric device. For this reason, the features of the corresponding embodiments of the inventive method are not described here again.

The invention also comprises the combinations of the described embodiments.

In the following, an exemplary implementation of the invention is described. The figures show:

Fig. 1 a schematic illustration of an embodiment of the inventive electric device;

Fig. 2 a schematic illustration of a tree structure;

Fig. 3 a schematic illustration of a tree structure;

Fig. 4 a schematic illustration of a tree structure with a point of known temperature;

Fig. 5 a schematic illustration of a tree structure with a point of known temperature;

Fig. 6 a schematic illustration of a tree structure for N=3 measurement points;

Fig. 7 a schematic illustration of an alternative tree structure for N=3 measurement points;

Fig. 8 a schematic illustration of an alternative tree structure for N=3 measurement points;

Fig. 9 a schematic illustration of an alternative tree structure for N=3 measurement points;

Fig. 10 a schematic illustration of another embodiment of the inventive electric device; and

Fig. 11 a schematic illustration of another embodiment of the inventive electric device with a circuitry of bent shape.

The embodiment explained in the following is a preferred embodiment of the invention. However, in the embodiment, the described components of the embodiment each represent individual features of the invention which are to be considered independently of each other and which each develop the invention also independently of each other and thereby are also to be regarded as a component of the invention in individual manner or in another than the shown combination. Furthermore, the described embodiment can also be supplemented by further features of the invention already described.

In the figures elements that provide the same function are marked with identical reference signs.

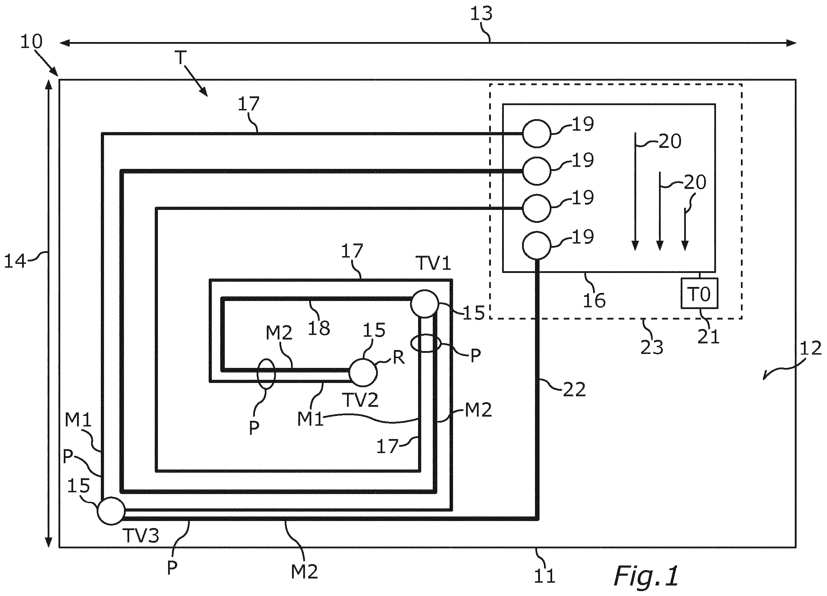

Fig. 1 illustrates an electric device 10 comprising a circuitry 11. The circuitry 11 is a printed circuit board, PCB, or a foil with electrically conductive tracks. The circuitry 11 can comprise electric and/or electronic components for providing a functionality. For example, the circuitry 11 can be a connector or driver for thermocouple temperature sensors.

The circuitry 11 is shown from a top view such that a top layer 12 can be seen. A length 13 and a width 14 of the circuitry 11 are indicated. In the layer 12 several measurement points 15 are provided and a control unit 16 can determine temperature values TV1, TV2, TV3 of temperatures at the measurement points 15. The control unit 16 can comprise a microcontroller and/or an analog-to-digital converter. For determining the temperature values TV1, TV2, TV3 the control unit 16 is connected to each of the corresponding measurement points 15 over a tree structure T. The tree structure T comprises a root R that is constituted by one measurement point 15. At each measurement point 15, a pair P of conductor elements 17, 18 begins, wherein each conductor element 17, 18 leads to either another measurement point 15 further down in the tree structure hierarchy or directly to a measurement electrode or pad 19 of the control unit 16. A conductor element 17, 18 can be, e.g., a wire or a track on a printed circuit board. For measuring the N=3 temperature values TV1, TV2, TV3 only N+1=4 pad 19 of control unit 16 are occupied or needed.

Each pair P of conductor elements 17, 18 forms a thermocouple. To this end, conductor elements 17 comprise a first material M1 and conductor elements 18 comprise a second element M2. The different materials are indicated in the figures by a corresponding thickness of the respective line (material M1 - thin line; material M2 - thick line) . The material M1 of conductor elements 17 is different from the material M2 of the conductor elements 18. This is indicated in the drawings by lines of different thickness. For example, the two different materials M1, M2 can be copper and constantan. Generally, the two different materials M1, M2 form a thermocouple. At the measurement points 15, the conductor elements are electrically connected, e.g. by soldering. Due to the temperature at measurement points 15, a respective voltage 20 is generated between the pads 19 at control unit 16. By measuring the voltages 20 at the pad 19, the temperature values TV1, TV2, TV3 can be determined as relative temperature values. The value of the voltage 20 is a function of the relative temperature between the measurement points 15 on one side and the ends of the conductor elements 17 and 18, which is, in the case of the embodiment of Fig. 1, the electrodes or pads 19.

For determining absolute temperature values at measurement points 15, a temperature sensor 21 can be provided that can be, e.g., an NTC resistor. Temperature sensor 21 can be arranged at the control unit 16 such that an absolute temperature value T0 measured by temperature sensor 21 is also valid for the control unit 16, especially for the pads 19 where voltages 20 are generated.

However, conductor elements 17, 18 can also be indirectly linked to the pads 19 over additional wires or tracks of identical material. These wires or tracks can be of the same material. The temperature sensor 21 can then be arranged at the ends of conductor elements 17, 18, i.e. at the end of the tree structure T.

The measurement of voltages 20 can be achieved by an analog-to-digital converter (A/D converter) of control unit 16.

A distribution element 23 can be provided in the area of temperature sensor 21 and control unit 16, especially pads 19, in order to provide a uniform absolute temperature T0 in the area where voltages 20 and absolute temperature value T0 are measured. The distribution element 23 can be, e.g., a metal plate or a metal foil.

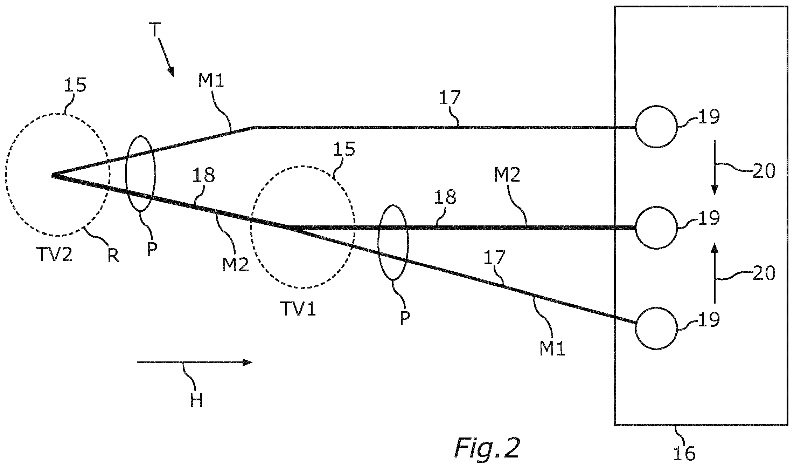

Fig. 2 illustrates the principle behind the measurement of the temperature values TV1, TV2, TV3 with only N+1=4 pads 19 occupied at control unit 16.

The tree structure T that is constructed from conductor elements 17, 18 connects all measurement points 15 to the control unit 16. The tree structure T is constructed according to the following rule: At the root R, the tree structure T begins with two conductor elements 17, 18 that form a thermocouple as they are made of different materials M1, M2 that provide the thermocouple effect. Starting from the root R and looking down the hierarchy H of the tree structure, as long as there is a measurement point 15 remaining, at least one of the conductor elements 17, 18 leads to such an unconnected measurement point 15 which integrates that measurement point 15 into the tree structure T. This rule leads to a tree structure T that connects N measurement points to the control unit 16 and that ends in only N+1 leaves of the tree structure T. A leave is represented by a measurement pad 19.

In Fig. 2, the hierarchy H is illustrated as an arrow pointing towards the direction of lower levels of the hierarchy. Root R is at the highest level, pads 19 are at the lowest level. Each level in between is defined by a respective measurement point 15.

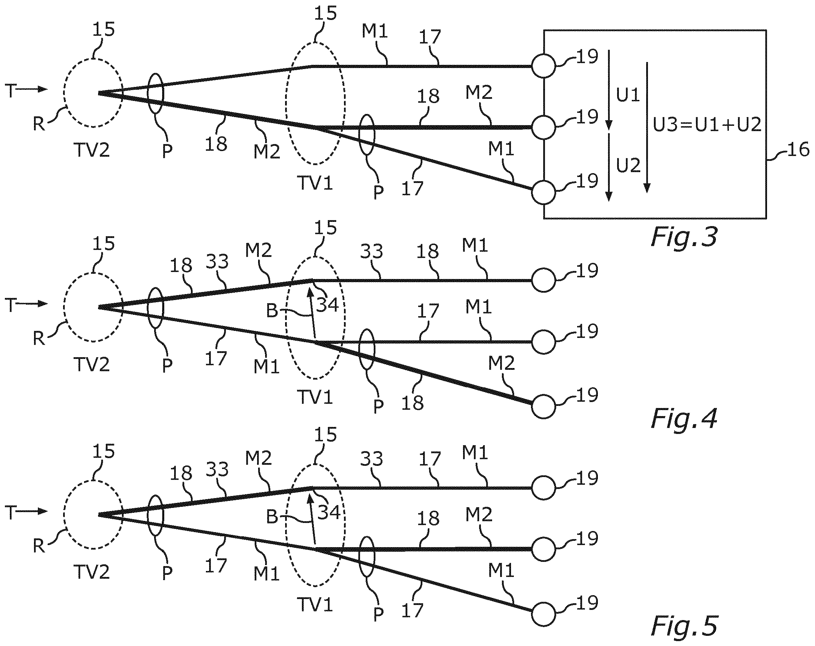

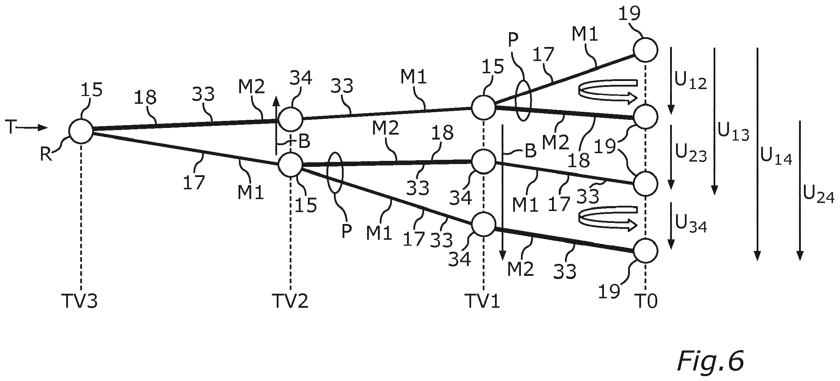

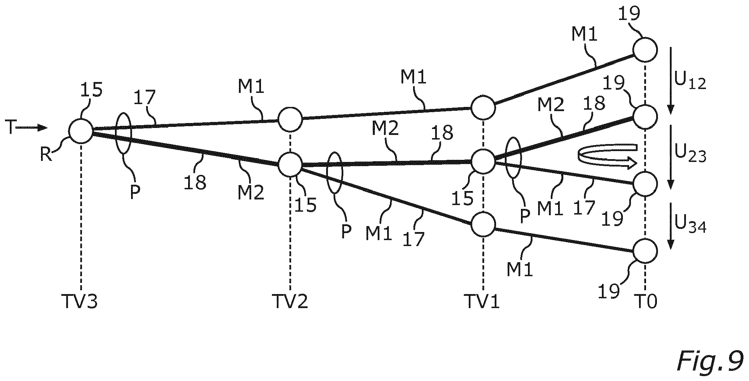

Fig. 3, Fig. 4, Fig. 5, Fig. 6, Fig. 7, Fig. 9 illustrate how the tree structure T can be constructed in different way from conductor elements 17, 18 that comprise only one homogenous segment (Fig. 3, Fig. 9) or two different connected segments (Fig. 4, Fig. 5, Fig. 6, Fig. 7, Fig. 8) and for N=2 measurement points (Fig. 3 to Fig. 5) or N=3 measurement points (Fig. 6 to Fig. 9), respectively.

Fig. 3 illustrates how the pads 19 of the control unit 16 may be electrically connected to two measurement points 15 by a in a tree structure T with homogeneous conductor elements 17, 18. "Homogenous" means that the each conductor element 17, 18 is of only one material (no variation of material). Naturally, the material M1 of each conductor element 17 and the material M2 of the each conductor element 18 differ to form a thermocouple arrangement. Note that according to the definition of a conductor element, conductor element 18 of the root R ends at the measurement point 15 for temperature value TV 1.

Control unit 16 may measure N=2 out of N+1=3 voltages U1, U2, U3 in order to obtain temperature values TV1, TV2 of the measurement points 15.

Fig. 4 and Fig. 5 illustrate how one conductor element 18 may comprise at least two segments 33 of different material M1, M2. A connection of the segments 33 is provided at a point 34 of known temperature. This point 34 can be arranged in a pre-defined region B of a measurement point 15 where the point 34 has the same temperature as the measurement point 15 or at least the temperatures differ less than a pre-defined threshold value. The region B can be defined by a circle with a radius of less than 1 cm, preferably less than 5 mm. The respective region B is represented in the drawings by an arrow indicating its radius.

As an alternative, a temperature sensor may be arranged at the point 34.

On the basis of the tree structures T shown in Fig. 3, Fig. 4, and Fig. 5, a network for measuring more than two temperature values TV1, TV2 can be constructed by combining or interconnecting more than the N=2 measurement points shown. This only requires N+1 pins or pads 19 for measuring N temperature values.

Fig. 6 to Fig. 9 illustrate, how the control unit 16 may determine N=3 temperature values TV1, TV2, TV3 as absolute values on the basis of voltage measurements at the pads 19 and on the basis of the measured absolute temperature value T0 of sensor 21 (see Fig. 1). The levels of the shown respective tree structures T are given by the measurements points for temperature values TV3, TV2, TV1, wherein the root R at TV3 is the highest level and TV2 and TV1 form a respective lower level resulting in the level hierarchy TV3->TV2->TV1 and the pads 19 form the leaves of structure T.

According to Fig 6, one conductor element 18 comprises two segments 33 of different material M1, M2 that are connected at a point 34 of known temperature (sensor-based temperature measurement or within a range B of a measurement point 15). The relative temperature values TV1, TV2, TV3 may be determined on the basis of the following set of equations:

$$U_{12} = Sm1 (TV1 - T0) - Sm2(TV1 - T0)$$

$$U_{34} = Sm1 (TV1 - T0) + Sm2(TV2 - TV1) - Sm1 (TV2 - TV1) - Sm2(TV1 - T0)$$

$$U_{34} = Sm2(TV2 - TV1) - Sm1 (TV2 - TV1) + U_{12}$$

$$U_{24} = + Sm2(TV1 - T0) + Sm1 (TV2 - TV1) + Sm2(TV3 - TV2) - Sm1(TV3 - TV2) - Sm1 (TV2 - TV1) - Sm2(TV1 - T0)$$

$$U_{24} = Sm2(TV3 - TV2) - Sm1(TV3 - TV2) + 0 + 0$$

where:

Sm1 is the Seedbeck coefficient of material M1
Sm2 is the Seedbeck coefficient of material M2
Sgb = (Sm2 - Sm1) is a relative Seedbeck coefficient of materials M2 and M1, which is (widely) refferred in the literature.
(TV1 - T0) is a temperature gradient

As a result $U_{12}$ is proportional to the temperature gradient (TV1 - T0), $U_{34}$ minus a known (derivable) offset is proportional to the temperature gradient (TV2 - TV1) and $U_{24}$ is proportional to the temperature gradient (TV3 - TV2).

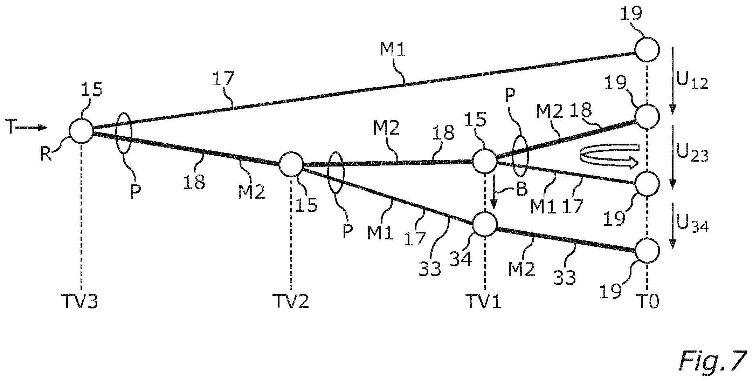

According to Fig 7, one conductor element 17 comprises two segments 33 of different material M1, M2 that are connected at a point 34 of known temperature (sensor-based temperature measurement or within a range B of a measurement point 15). The relative temperature values TV1, TV2, TV3 may be determined on the basis of the following set of equations:

$$U_{23} = Sm2 (TV1 - T0) - Sm1(TV1 - T0)$$

$$U_{24} = Sm2 (TV1 - T0) + Sm2(TV2 - TV1) - Sm1 (TV2 - TV1) - Sm2(TV1 - T0)$$

$$U_{24} = Sm2(TV2 - TV1) - Sm1 (TV2 - TV1) + 0$$

$$U_{12} = Sm1 (TV3 - T0) - Sm2(TV3 - T0)$$

As a result $U_{23}$ is proportional to the temperature gradient (TV1 - T0), $U_{24}$ is proportional to the temperature gradient (TV2 - TV1) and $U_{12}$ is proportional to the temperature gradient (TV3 - T0).

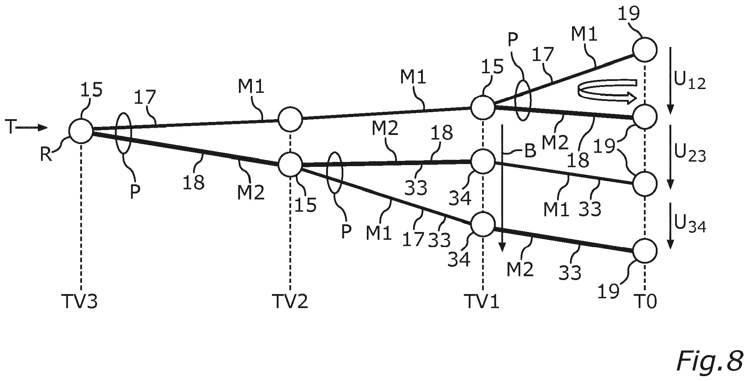

According to Fig 8, one conductor element 17 comprises two segments 33 of different material M1, M2 that are connected at a point 34 of known temperature (sensor-based temperature measurement or within a range B of a measurement point 15). The relative temperature values TV1, TV2, TV3 may be determined on the basis of the following set of equations:

$$U_{12} = Sm1 (TV1 - T0) - Sm2(TV1 - T0)$$

$$U_{34} = Sm2 (TV1 - T0) + Sm2(TV2 - TV1) - Sm1 (TV2 - TV1) - Sm2(TV1 - T0)$$

$$U_{34} = Sm2(TV2 - TV1) - Sm1 (TV2 - TV1) + 0$$

$$U_{13} = Sm1 (TV3 - T0) - Sm2(TV3 - T0)$$

As a result $U_{12}$ is proportional to the temperature gradient (TV1 - T0), $U_{34}$ is proportional to the temperature gradient (TV2 - TV1) and $U_{13}$ is proportional to the temperature gradient (TV3 - T0).

According to Fig 9, all conductor elements 17, 18 are homogeneous, i.e. of only one respective material M1, M2. The relative temperature values TV1, TV2, TV3 may be determined on the basis of the following set of equations:

$$U_{23} = Sm2 (TV1 - T0) - Sm1(TV1 - T0)$$

$$U_{24} = Sm2 (TV2 - T0) - Sm1 (TV2 - T0)$$

$$U_{12} = Sm1 (TV3 - T0) - Sm2(TV3 - T0)$$

As a result $U_{23}$ is proportional to the temperature gradient (TV1 - T0), $U_{24}$ is proportional to the temperature gradient (TV2 - T0) and $U_{12}$ is proportional to the temperature gradient (TV3 - T0).

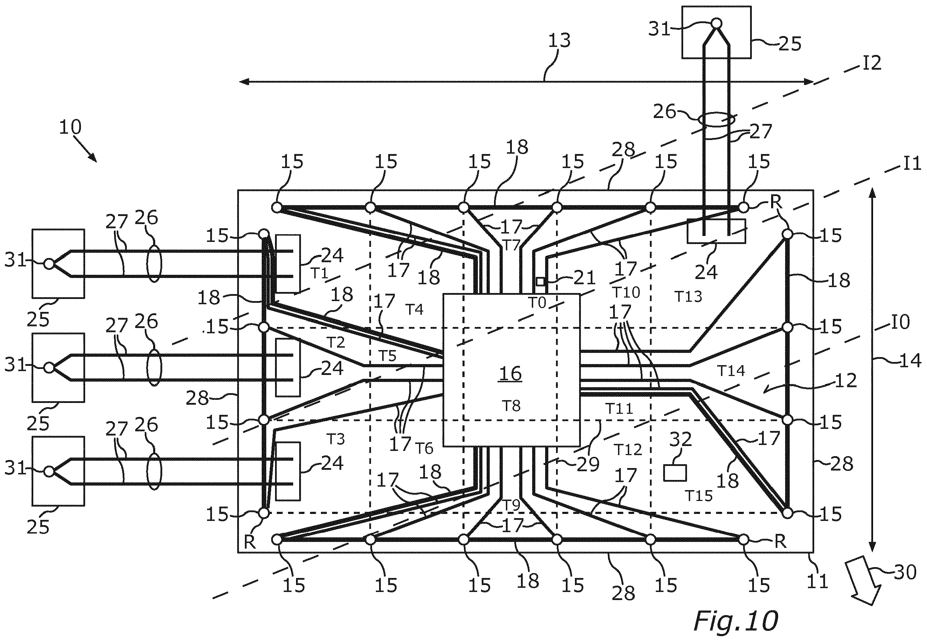

Fig. 10 illustrates an electric device 10 with a circuitry 11, e.g. a printed circuit board, which provides several connection units 24 to each of which a respective external temperature sensor 25 may be connected. Each temperature sensor 25 may provide a pair 26 of thermocouple wires 27. The control unit 16 may be designed to determine a respective absolute temperature T1, T2, T3, T13 at each of the connection units 24. It uses relative temperature values determined at several measurement points 15 arranged in the layer 12 of the circuitry 11. The measurement may be performed according to the principle illustrated in Fig. 2.

The drawing illustrates an embodiment where four wires or tracks provide a row of conductor elements 18 that are arranged at the sides or edges 28, i.e. along the length 13 and the width 14 of the circuitry 11. Alternatively, one single wire or track may form conductor elements 18 that can be arranged along two or more edges 28 of the circuitry 11. Each wire or track thus connects more than one measurement point 15..

For determining the absolute temperature values T1, T2, T3, T13, a temperature sensor 21 can be provided at control unit 16 for measuring a single absolute temperature value T0.

On the basis of the temperature values determined at measurement points 15 and the absolute temperature value T0 measured by temperature sensor 21, interpolated temperature values T1,..., T15 for different areas or locations or fields of the circuitry 11 can be interpolated. Borders 29 of the fields are illustrated in Fig. 3. Additionally or alternatively, a gradient vector 30 of the temperature on the layer 12 can be determined. Additionally or alternatively, isolines I0, I1, I2 of a temperature field can be determined by control unit 16. An isoline is a line that links all points of the layer 12 that have a respective common temperature.

On the basis of the absolute temperature values T1, T2, T3, T13 determined at connection units 24 or in the corresponding fields, control unit 16 can determine absolute temperature values at hot junctions 31 of thermocouple wires 27 of the sensors 25 by additionally measuring a voltage generated between wires 27 of each respective pair 26.

For a plausibility check, a further temperature sensor 32 may be provided at a distance from the temperature sensor 21. Temperature sensor 32 can be, e.g., an NTC resistor. If a temperature difference between temperature sensors 21 and 32 is greater than a threshold value, an error signal can be generated by control unit 16. The threshold value can be in a range of, e.g., 10°C to 30°C. For example, the threshold value can be 20°C.

Control unit 16 is thus checking the temperature gradient more precisely, so the temperature measurement can be more precise. Instead of two NTC resistors, the use of one single temperature sensor 21 is sufficient and the thermocouples formed by one element made in PCB and one element attached on the PCB. Voltage 20 on the output of each thermocouple is equal to the temperature gradient.

More precise measurement of the temperature gradient across the PCB is achieved. This gives the advantage of more precise temperature gradient.

Instead of measuring temperature at two points, electric device 10 is able to estimate temperature gradients across the whole PCB.

The general rule for constructing the tree structure T is the following: Let's call all segments between neighboring measurement points (15) or between a measurement point (15) and the control unit (16) a "stage".
The general rule for constructing the tree structure T is that several stages of a thermocouple network (Fig. 3 to 5 is a 2-stage thermocouple network, Fig. 6 to Fig. 9 is a 3-stage thermocouple network, a 1-stage network has two segments only) are constructed in a way that:

- in the next new stage one has to add one (segment / wire) by forking (one / at least one) conductor element (17,18)
- on not forked condutor elements (17,18) the material can change or stay (depending on the layout management)
- new stage can use any material combination M1, M2 not depending anyhow on the previous stage, but at least one (wire / segment) has to use different material to the other (segments / wires)
- one has to avoid creating pair P of (wires / segments) of identical material

This will result in N+1 measurement pads (19) to N temperature measurements points (15).

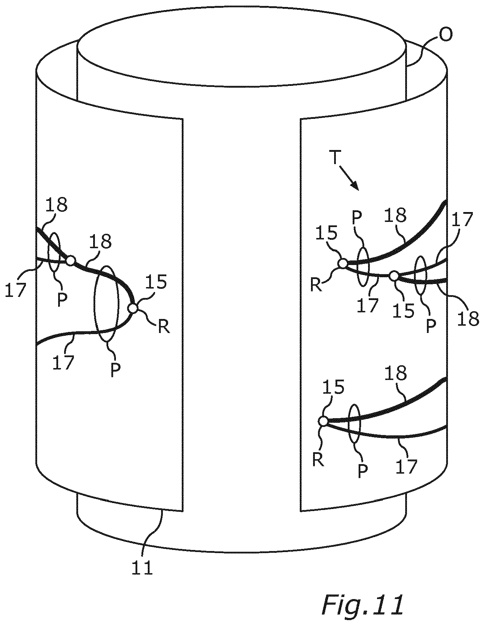

Fig. 11 illustrates a circuitry 11 that is designed as a foil that is wrapped around an object O. In other words, one aspect of the invention is an arrangement of an electric device according to the invention, wherein the circuitry is designed as a foil and is wrapped around an object for measuring surface temperature values of the object.

With the circuitry 11 it is possible to measure the surface temperature at several measurement points 15. The circuitry 11 may generally comprise a tree structure T with more than one root R or several tree structures with one root each.

The object O can be a part or an electric vehicles, e.g. a part of an electric engine. In the example shown, at object O no measurement of a high temperature at one place is performed, but a measurement of lower temperature values (below 300 °C) at several different measurement points.

Overall, the example shows how temperature gradients on a circuitry can be determined.

**Claims**

1.   Electric device (10) comprising a circuitry (11) and a control unit comprising measurement pads (19) (16), wherein the circuitry (11) is a printed circuit board or a foil with integrated electrically conductive tracks and wherein the control unit (16) is designed to determine local temperature values (TV1, TV2, TV3) at N different measurement points (15) of the circuitry (11), wherein N is equal to or greater than 2 and wherein the control unit (16) is electrically connected to the measurement points (15) by electric conductor elements (17), wherein the conductor elements (17, 18) form a tree structure (T) that connects all measurement points (15) to the control unit (16), wherein starting from at least one measurement point (15) forming a respective root (R) of the tree structure (T) a respective pair (P) of conductor elements (17, 18) begins at each measurement point (P), the pair (P) forming a thermocouple at the respective measurement point (15) and each conductor element (17, 18) of the pair (P) leading to either a measurement point (15) of a lower level of the tree structure (T) or to the control unit (16), wherein at the control unit (16) N+1 conductor elements (17, 18) of the tree structure (T) are electrically connected to the measurement pads (19) of the control unit (16) and wherein the control unit (16) is designed to determine the respective temperature value (TV1, TV2, TV3) of each measurement point (15) as a function of a respective voltage (20) that is produced between the measurement pads (19) by the thermocouples, **characterized in that** the circuitry (11) comprises several layers each comprising electrically conductive tracks and the materials (M1, M2) for forming the respective thermocouple are provided by different layers of the circuitry (11).

2.   Electric device (10) according to claim 1, wherein at least one conductor element (17, 18) is constructed of several segments (33) of different material (M1, M2) and wherein a change of material (M1, M2) within the respective conductor element (17, 18) occurs at a respective point (34) of known temperature.

3. Electric device (10) according to claim 2, wherein at the respective point (34) of known temperature a temperature sensor is positioned or the point (34) of known temperature is within a pre-defined range (B) of one of the measurement points (15).

4. Electric device (10) according to any of the preceding claims, wherein the function of the respective voltage (20) that is produced between the measurement pads (19) by the thermocouples is based on the thermoelectric effect and describes a relative temperature difference between the control unit (16) and the respective measurement point (15).

5. Electric device (10) according to any of the preceding claims, wherein a temperature sensor (21) for measuring an absolute temperature value (T0) is positioned at the control unit (16) and the control unit (16) is designed to determine a respective absolute temperature value (T0) for one or several or all of the measurement points (15) on the basis of the measured absolute temperature value (T0) and the respective temperature value (TV1, TV2, TV3) of the measurement point (15).

6. Electric device (10) according to claim 5, wherein the circuitry (11) comprised several connection units (24) for connecting a respective pair (26) of thermocouple wires (27) of a respective external temperature sensor (25) and wherein the control unit (16) is designed to determine a respective absolute temperature (T1, T2, T3, T13) at each of the connection units (24) as a function of the respective temperature value (TV1, TV2, TV3) of each of the measurement points (15) and the measured absolute temperature value (T0).

7. Electric device (10) according to claim 5 or 6, wherein a heat distribution element (23) is arranged in a connection area where the measurement pads (19) and the temperature sensor (21) are arranged.

8. Electric device (10) according to any of the claims 5 to 7, wherein an additional temperature sensor (32) for measuring an additional absolute temperature value is arranged on the circuitry (11) and the control unit (16) is designed to determine a temperature difference value between the absolute temperature values (T0) of the temperature sensors (21, 32) and to generate an error signal, if the temperature difference value is greater than a predefined value.

9. Electric device (10) according to any of the preceding claims, wherein the control unit (16) is designed to calculate interpolated temperature values (T1,...,T15) along the circuitry (11) between the measurement points (15) on the basis of the respective temperature value (TV1, TV2, TV3) of each measurement point (15) and a predefined interpolation function.

10. Electric device (10) according to any of the preceding claims, wherein the control unit (16) is designed to calculate a temperature gradient field (30) along the circuitry (11) on the basis of the respective temperature value (TV1, TV2, TV3) of each measurement point (15) and a predefined heat dissipation model.

11. Electric device (10) according to any of the preceding claims, wherein the circuitry (11) comprises an electronic circuit that is designed to receive a supply voltage over two supply electrodes, where one supply electrode is configured to be connected to one of the conductor elements (17, 18) of the tree structure (T) and the other supply electrode is connected to another conductor element (17, 18) of the tree structure (T).

12. Method for determining local temperatures (TV1, TV2, TV3) at different measurement points (15) of a circuitry (11) of an electric device (10), wherein the circuitry (11) is a printed circuit board or a foil with integrated electrically conductive tracks and wherein a control unit (16) comprising measurement pads (19) determines local temperature values (TV1, TV2, TV3) at N different measurement points (15) of the circuitry (11), wherein N is equal to or greater than 2 and wherein the control unit (16) is electrically connected to the measurement points (15) by electric conductor elements (17), wherein the conductor elements (17, 18) form a tree structure (T) that connects all measurement points (15) to the control unit (16), wherein starting from at least one measurement point (15) forming a respective root (R) of the tree structure (T) a respective pair (P) of conductor elements (17, 18) begins at each measurement point (15), the pair (P) forming a thermocouple at the respective measurement point (15) and each conductor element (17, 18) of the pair (P) leading to either a measurement point (15) of a lower level of the tree structure (T) or to the control unit (16), wherein at the control unit (16) N+1 conductor elements (17, 18) of the tree structure (T) are electrically connected to the measurement pads (19) of the control unit (16) and wherein the control unit (16) determines the respective temperature value (TV1, TV2, TV3) of each measurement point (15) as a function of a respective voltage (20) that is produced between the measurement pads (19) by the thermocouples, **characterized in that**

the circuitry (11) comprises several layers each comprising electrically conductive tracks and the materials (M1, M2) for forming the respective thermocouple are provided by different layers of the circuitry (11).

**Patentansprüche**

1. Elektrische Vorrichtung (10), die eine Schaltung (11) und eine Steuereinheit (16) umfasst, die Messstellen (19) umfasst, wobei die Schaltung (11) eine gedrückte Leiterplatte oder eine Folie mit integrierten elektrisch leitfähigen Bahnen ist, und wobei die Steuereinheit (16) ausgelegt ist zum Ermitteln von lokalen Temperaturwerten (TV1, TV2, TV3) an N verschiedenen Messpunkten (15) der Schaltung (11), wobei N gleich oder größer als 2 ist und wobei die Steuereinheit (16) durch elektrische Leiterbahnelemente (17) mit den Messpunkten (15) elektrisch verbunden ist, wobei die Leiterbahnelemente (17, 18) eine Baumstruktur (T) bilden, die alle Messpunkte (15) mit der Steuereinheit (16) verbindet, wobei, beginnend bei mindestens einem Messpunkt (15), der eine entsprechende Wurzel (R) der Baumstruktur (T) bildet, ein entsprechendes Paar (P) Leiterbahnelemente (17, 18) an jedem Messpunkt (P) beginnt, wobei das Paar (P) ein Thermoelement an dem entsprechenden Messpunkt (15) bildet und wobei jedes Leiterbahnelement (17, 18) des Paars (P) entweder zu einem Messpunkt (15) einer niedrigeren Ebene der Baumstruktur (T) oder zu der Steuereinheit (16) führt, wobei an der Steuereinheit (16) N + 1 Leiterbahnelemente (17, 18) der Baumstruktur (T) mit den Messstellen (19) der Steuereinheit (16) elektrisch verbunden sind, und wobei die Steuereinheit (16) ausgelegt ist zum Ermitteln des jeweiligen Temperaturwerts (TV1, TV2, TV3) von jedem Messpunkt (15) als eine Funktion einer entsprechenden Spannung (20), die durch die Thermoelemente zwischen den Messstellen (19) erzeugt wird,
**dadurch gekennzeichnet, dass**
die Schaltung (11) mehrerer Schichten umfasst, die jeweils elektrisch leitfähige Bahnen umfassen, und dadurch, dass die Materialien (M1, M2) zum Bilden der entsprechenden Thermoelemente durch die verschiedenen Schichten der Schaltung (11) bereitgestellt werden.

2. Elektrische Vorrichtung (10) nach Anspruch 1, wobei mindestens ein Leiterbahnelement (17, 18) aus mehreren Segmenten (33) aus unterschiedlichen Materialien (M1, M2) aufgebaut ist, und wobei eine Änderung des Materials (M1, M2) innerhalb des jeweiligen Leiterbahnelements (17, 18) an einem entsprechenden Punkt (34) mit einer bekannten Temperatur auftritt.

3. Elektrische Vorrichtung (10) nach Anspruch 2, wobei an dem entsprechenden Punkt (34) mit der bekannten Temperatur ein Temperatursensor angebracht ist oder wobei der Punkt (34) mit der bekannten Temperatur innerhalb eines vordefinierten Bereichs (B) von einem der Messpunkte (15) liegt.

4. Elektrische Vorrichtung (10) nach einem der vorhergehenden Ansprüche, wobei die Funktion der entsprechenden Spannung (20), die zwischen den Messstellen (19) durch die Thermoelemente erzeugt wird, auf einem thermoelektrischen Effekt beruht und eine relative Temperaturdifferenz zwischen der Steuereinheit (16) und dem entsprechenden Messpunkt (15) beschreibt.

5. Elektrische Vorrichtung (10) nach einem der vorhergehenden Ansprüche, wobei ein Temperatursensor (21) zum Messen eines absoluten Temperaturwerts (T0) an der Steuereinheit (16) angebracht ist und wobei die Steuereinheit (16) ausgelegt ist zum Ermitteln eines entsprechenden absoluten Temperaturwerts (T0) für einen oder mehrere oder alle Messpunkte (15) auf der Grundlage des gemessenen absoluten Temperaturwerts (T0) und des entsprechenden Temperaturwerts (TV1, TV2, TV3) des Messpunkts (15).

6. Elektrische Vorrichtung (10) nach Anspruch 5, wobei die Schaltung (11) mehrere Verbindungseinheiten (24) zum Anschließen eines jeweiligen Paars (26) von Thermoelementkabeln (27) eines entsprechenden externen Temperatursensors (25) umfasst und wobei die Steuereinheit (16) ausgelegt ist zum Ermitteln einer jeweiligen absoluten Temperatur (T1, T2, T3, T13) an jeder der Verbindungseinheiten (24) als eine Funktion des entsprechenden Temperaturwerts (TV1, TV2, TV3) von Jedem der Messpunkte (15) und des gemessenen absoluten Temperaturwerts (T0).

7. Elektrische Vorrichtung (10) nach Anspruch 5 oder 6, wobei ein Wärmeverteilungselement (23) in einem Anschlussbereich angeordnet ist, in dem die Messstellen (19) und der Temperatursensor (21) angeordnet sind.

8. Elektrische Vorrichtung (10) nach einem das der Ansprüche 5 bis 7, wobei ein zusätzlicher Temperatursensor (32) zum Messen eines zusätzlichen absoluten Temperaturwerts in der Schaltung (11) angeordnet ist und wobei die

**EP 3 534 125 B1**

Steuereinheit (16) ausgelegt ist zum Ermitteln eines Temperaturdifferenzwerts zwischen den absoluten Temperaturwerten (T0) der Temperatursensoren (21, 32) und zum Erzeugen eines Fehlersignals, wenn der Temperaturdifferenzwert größer als ein vordefinierter Wert ist.

9. Elektrische Vorrichtung (10) nach einem der vorhergehenden Ansprüche, wobei die Steuereinheit (16) ausgelegt ist zum Berechnen von interpolierten Temperaturwerten (T1, ..., T15) entlang der Schaltung (11) zwischen den Messpunkten (15) auf der Grundlage des jeweiligen Temperaturwerts (TV1, TV2, TV3) von jedem Messpunkt (15) und einer vordefinierten Interpolationsfunktion.

10. Elektrische Vorrichtung (10) nach einem der vorhergehenden Ansprüche, wobei die Steuereinheit (16) ausgelegt ist zum Berechnen eines Temperaturgradientenfeldes (30) entlang der Schaltung (11) auf der Grundlage des jeweiligen Temperaturwerts (TV1, TV2, TV3) von jedem Messpunkt (15) und eines vordefinierten Wärmeableitungsmodells.

11. Elektrische Vorrichtung (10) nach einem der vorhergehenden Ansprüche, wobei die Schaltung (11) einen elektronischen Schaltkreis umfasst, der ausgelegt ist zum Empfangen einer Versorgungsspannung über zwei Versorgungselektroden, wobei eine Versorgungselektrode konfiguriert ist, um mit Einem der Leiterbahnelemente (17, 18) der Baumstruktur (T) verbunden zu werden, und wobei die andere Versorgungselektrode mit einem anderen Leiterbahnelement (17, 18) der Baumstruktur (T) verbunden ist.

12. Verfahren zum Ermitteln einer lokalen Temperatur (TV1, TV2, TV3) an verschiedenen Messpunkten (15) einer Schaltung (11) einer elektrischen Vorrichtung (10), wobei die Schaltung (11) eine gedruckte Leiterplatte oder eine Folie mit integrierten elektrisch leitfähigen Bahnen ist, und wobei eine Steuereinheit (16), die Messstellen (19) umfasst, lokale Temperaturwerten (TV1, TV2, TV3) an N verschiedenen Messpunkten (15) der Schaltung (11) ermittelt, wobei N gleich oder größer als 2 ist und wobei die Steuereinheit (16) durch elektrische Leiterbahnelemente (17) mit den Messpunkten (15) elektrisch verbunden ist, wobei die Leiterbahnelemente (17, 18) eine Baumstruktur (T) bilden, die alle Messpunkte (15) mit der Steuereinheit (16) verbinden, wobei, beginnend bei mindestens einem Messpunkt (15), der eine entsprechende Wurzel (R) der Baumstruktur (T) bildet, ein entsprechendes Paar (P) Leiterbahnelemente (17, 18) an jedem Messpunkt (15) beginnt, wobei das Paar (P) ein Thermoelement an dem entsprechenden Messpunkt (15) bildet und wobei jedes Leiterbahnelement (17, 18) des Paars (P) entweder zu einem Messpunkt (15) einer niedrigeren Ebene der Baumstruktur (T) oder zu der Steuereinheit (16) führt, wobei an der Steuereinheit (16) N + 1 Leiterbahnelemente (17, 18) der Baumstruktur (T) mit den Messstellen (19) der Steuereinheit (16) elektrisch verbunden sind, und wobei die Steuereinheit (16) den jeweiligen Temperaturwert (TV1, TV2, TV3) von jedem Messpunkt (15) als eine Funktion einer entsprechenden Spannung (20) ermittelt, die durch die Thermoelemente zwischen den Messstellen (19) erzeugt wird,
**dadurch gekennzeichnet, dass**
die Schaltung (11) mehrerer Schichten umfasst, die jeweils elektrisch leitfähige Bahnen umfassen, und dadurch, dass die Materialien (M1, M2) zum Bilden der entsprechenden Thermoelemente durch die verschiedenen Schichten der Schaltung (11) bereitgestellt werden.

**Revendications**

1. Dispositif électrique (10) comprenant un circuit (11) et une unité de commande (16) comprenant des plages de mesure (19), le circuit (11) étant une carte de circuit imprimé ou une feuille avec des pistes électriquement conductrices intégrées et l'unité de commande (16) étant conçue pour déterminer des valeurs de température locales (TV1, TV2, TV3) en N points de mesure différents (15) du circuit (11), N étant égal ou supérieur à 2 et l'unité de commande (16) étant connectée électriquement aux points de mesure (15) par des éléments conducteurs électriques (17), les éléments conducteurs (17, 18) formant une structure arborescente (T) qui connecte tous les points de mesure (15) à l'unité de commande (16), à partir d'au moins un point de mesure (15) formant une racine respective (R) de la structure arborescente (T), une paire respective (P) d'éléments conducteurs (17, 18) commençant au niveau de chaque point de mesure (P), la paire (P) formant un thermocouple au point de mesure respectif (15) et chaque élément conducteur (17, 18) de la paire (P) conduisant soit à un point de mesure (15) d'un niveau inférieur de l'arborescence (T), soit à l'unité de commande (16), au niveau de l'unité de commande (16), N+1 éléments conducteurs (17, 18) de la structure arborescente (T) étant connectés électriquement aux plages de mesure (19) de l'unité de commande (16) et l'unité de commande (16) étant conçue pour déterminer la valeur de température respective (TV1, TV2, TV3) de chaque point de mesure (15) en fonction d'une tension respective (20) qui est produite entre les plages de mesure (19) par les thermocouples,

**caractérisé en ce que**
le circuit (11) comprend plusieurs couches comprenant chacune des pistes électriquement conductrices et les matériaux (M1, M2) pour former le thermocouple respectif sont fournis par différentes couches du circuit (11).

2. Dispositif électrique (10) selon la revendication 1, au moins un élément conducteur (17, 18) étant constitué de plusieurs segments (33) de différents matériaux (M1, M2) et un changement de matériau (M1, M2) dans l'élément conducteur respectif (17, 18) se produisant en un point respectif (34) de température connue.

3. Dispositif électrique (10) selon la revendication 2, un capteur de température étant positionné au niveau du point respectif (34) de température connue ou le point (34) de température connue se trouvant dans une plage prédéfinie (B) de l'un des points de mesure (15).

4. Dispositif électrique (10) selon l'une quelconque des revendications précédentes, la fonction de la tension (20) respective qui est produite entre les plages de mesure (19) par les thermocouples étant basée sur l'effet thermoélectrique et décrivant une différence de température relative entre l'unité de commande (16) et le point de mesure (15) respectif.

5. Dispositif électrique (10) selon l'une quelconque des revendications précédentes, un capteur de température (21) destiné à mesurer une valeur absolue de température (T0) étant positionné au niveau de l'unité de commande (16) et l'unité de commande (16) étant conçue pour déterminer une valeur absolue de température respective (T0) pour un ou plusieurs ou tous les points de mesure (15) sur la base de la valeur absolue de température mesurée (T0) et de la valeur de température respective (TV1, TV2, TV3) du point de mesure (15).

6. Dispositif électrique (10) selon la revendication 5, le circuit (11) comprenant plusieurs unités de connexion (24) pour connecter une paire respective (26) de fils de thermocouple (27) d'un capteur de température externe respectif (25) et l'unité de commande (16) étant conçue pour déterminer une température absolue respective (T1, T2, T3, T13) au niveau de chacune des unités de connexion (24) en fonction de la valeur de température respective (TV1, TV2, TV3) de chacun des points de mesure (15) et de la valeur de température absolue mesurée (T0).

7. Dispositif électrique (10) selon la revendication 5 ou 6, un élément de distribution de chaleur (23) étant agencé dans une zone de connexion où sont agencés les plages de mesure (19) et le capteur de température (21).

8. Dispositif électrique (10) selon l'une quelconque des revendications 5 à 7, un capteur de température supplémentaire (32) pour la mesure d'une valeur de température absolue supplémentaire étant agencé sur le circuit (11) et l'unité de commande (16) étant conçue pour déterminer une valeur de différence de température entre les valeurs de température absolues (T0) des capteurs de température (21, 32) et pour générer un signal d'erreur, si la valeur de différence de température est supérieure à une valeur prédéfinie.

9. Dispositif électrique (10) selon l'une quelconque des revendications précédentes, l'unité de commande (16) étant conçue pour calculer des valeurs de température interpolées (T1, ..., T15) le long du circuit (11) entre les points de mesure (15) sur la base de la valeur de température respective (TV1, TV2, TV3) de chaque point de mesure (15) et d'une fonction d'interpolation prédéfinie.

10. Dispositif électrique (10) selon l'une quelconque des revendications précédentes, l'unité de commande (16) étant conçue pour calculer un champ de gradient de température (30) le long des circuits (11) sur la base de la valeur de température respective (TV1, TV2, TV3) de chaque point de mesure (15) et d'un modèle de dissipation de chaleur prédéfini.

11. Dispositif électrique (10) selon l'une quelconque des revendications précédentes, le circuit (11) comprenant un circuit électronique qui est conçu pour recevoir une tension d'alimentation par l'intermédiaire de deux électrodes d'alimentation, une électrode d'alimentation étant configurée pour être connectée à l'un des éléments conducteurs (17, 18) de la structure arborescente (T) et l'autre électrode d'alimentation étant connectée à un autre élément conducteur (17, 18) de la structure arborescente (T).

12. Procédé pour déterminer des températures locales (TV1, TV2, TV3) en différents points de mesure (15) d'un circuit (11) d'un dispositif électrique (10), le circuit (11) étant une carte de circuit imprimé ou une feuille avec des pistes électriquement conductrices intégrées et une unité de commande (16) qui comprend des plages de mesure (19) déterminant des valeurs de température locales (TV1, TV2, TV3) en N points de mesure (15) différents du circuit (11), N étant égal ou supérieur à 2 et l'unité de commande (16) étant connectée électriquement aux points de mesure (15) par des éléments conducteurs électriques (17), les éléments conducteurs (17, 18) formant une structure arborescente (T) qui connecte tous les points de mesure (15) à l'unité de commande (16), à partir d'au moins un point de mesure (15) formant une racine respective (R) de la structure arborescente (T), une paire respective (P) d'éléments conducteurs (17, 18) commençant à chaque point de mesure (15), la paire (P) formant un thermocouple au niveau du point de mesure respectif (15) et chaque élément conducteur (17, 18) de la paire (P) menant soit à un point de mesure (15) d'un niveau inférieur de la structure arborescente (T), soit à l'unité de commande (16), au niveau de l'unité de commande (16), N+1 éléments conducteurs (17, 18) de la structure arborescente (T) étant connectés électriquement aux plages de mesure (19) de l'unité de commande (16) et l'unité de commande (16) déterminant la valeur de température respective (TV1, TV2, TV3) de chaque point de mesure (15) en fonction d'une tension respective (20) qui est produite entre les plages de mesure (19) par les thermocouples,
**caractérisé en ce que**
le circuit (11) comprend plusieurs couches comprenant chacune des pistes électriquement conductrices et les matériaux (M1, M2) pour former le thermocouple respectif sont fournis par différentes couches du circuit (11).

*Fig.1*

EP 3 534 125 B1

*Fig.2*

EP 3 534 125 B1

*Fig.3*

*Fig.4*

*Fig.5*

EP 3 534 125 B1

*Fig.6*

*Fig.7*

EP 3 534 125 B1

Fig.8

EP 3 534 125 B1

Fig.9

*Fig.10*

EP 3 534 125 B1

Fig.11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9279731 A
- US 6472612 A
- US 5180440 A
- US 7603205 A
- US 9285278 A
- US 2005259719 A1
- WO 2011094658 A1
- WO 2011152776 A1